# EUROPÄISCHE PATENTSCHRIFT

(11) **EP 2 708 795 B1**
(45) Veröffentlichungstag und Bekanntmachung des Hinweises auf die Patenterteilung: **09.03.2016**
(21) Anmeldenummer: 13176375.7
(22) Anmeldetag: 12.07.2013
(51) Int. Cl.: F21K 99/00, F21V 8/00, B60Q 3/04, H03K 17/96

(54) **Beleuchtungseinheit**
Lighting unit
Unité d' éclairage

(30) Priorität: 18.09.2012 DE 102012216665
(43) Veröffentlichungstag der Anmeldung: 19.03.2014
(73) Patentinhaber: WÜRTH ELEKTRONIK GmbH & Co. KG, 74676 Niedernhall (DE)
(72) Erfinder: Kostelnik, Jan, 74592 Kichberg (DE)
(74) Vertreter: Richardt Patentanwälte PartG mbB

(56) Entgegenhaltungen:
- WO-A1-2009/036552
- DE-U1-202008 009 589

## Beschreibung

Die Erfindung betrifft eine Beleuchtungseinheit mit einem Leuchtmittel, welche eine oder mehrere LEDs für Beleuchtungszwecke aufweist, sowie ein Möbelstück mit einer integrierten Beleuchtungseinheit, ein Kraftfahrzeug-Innenverkleidungsteil mit einer integrierten Beleuchtungseinheit sowie ein Verfahren zur Herstellung einer Beleuchtungseinheit.

Aus dem Stand der Technik sind verschiedene Beleuchtungseinheiten mit LEDs bekannt, wie zum Beispiel aus DE 20 2006 017 924 U1, DE 10 2010 063 735 A1, DE 20 2007 010 458 U1 und EP 1 848 254 A2.

WO 2009/036552 offenbart ein Beleuchtungssystem mit einem elektrolumineszierenden Streifen als erste Schicht, einem gedruckten Sensor-Leiterplatte (Sensor-PCB) als zweite Schicht, einer Grafikschicht 64 als dritte Schicht und einer Deckplatte. Die erste Schicht ist zwischen der zweiten und dritten Schicht angeordnet. Die dritte Schicht ist zwischen der zweiten Schicht und der Deckplatte angeordnet.

Der Erfindung liegt demgegenüber die Aufgabe zugrunde, eine verbesserte Beleuchtungseinheit zu schaffen.

Die der Erfindung zugrunde liegende Aufgabe wird mit den Merkmalen des Patentanspruchs 1 gelöst. Bevorzugte Ausführungsformen der Erfindung sind in den abhängigen Patentansprüchen angegeben.

Nach Ausführungsformen der Erfindung hat die Beleuchtungseinheit eine Leiterplatte. Eine solche Leiterplatte wird auch als Platine, gedruckte Schaltung oder Printed Circuit Board (PCB) bezeichnet. Die Leiterplatte kann eine Bestückungsseite mit elektronischen Bauteilen und eine Lötseite mit einem Lötstopplack aufweisen. Es kann sich auch um eine mehrschichtige Leiterplatte, insbesondere eine sogenannte Multilayer PCB handeln. Insbesondere können verschiedene Schaltungsebenen der Leiterplatte durch sogenannte Vias miteinander elektrisch kontaktiert sein. Die Leiterplatte kann auch so ausgebildet sein, dass die elektronischen Bauelemente in dem Inneren der Leiterplatte eingebettet sind. Entsprechende Techniken zur Integration von Bauelementen in das Innere eine Leiterplatte sind an sich aus dem Stand der Technik bekannt, vgl. Flexible Schaltungsträger mit eingebetteten, flexiblen ICs, Proceedings Elektronische Baugruppen und Leiterplatten - EBL 2012 (GMM-FB 71)- Hochentwickelte Baugruppen in Europa -6. DVS/GMM-Tagung, 02/14/2012 - 02/15/2012, Dr. Jan Kostelnik et. al.

Nach Ausführungsformen der Erfindung ist das Leuchtmittel auf der Bestückungsseite der Leiterplatte angeordnet. Die Dekorschicht kann die elektronischen Bauelemente auf der Bestückungsseite sowie die auf der Bestückungsseite befindlichen Leiterbahnen und das Leuchtmittel überdecken und einen Niveauausgleich schaffen, sodass die resultierende Dekorschicht auf ihrer Außenseite glatt und ohne Unterbrechungen ist.

Die Leiterplatte kann auch so ausgebildet sein, dass die elektronischen Bauelemente und die diese miteinander verbindenden Leiterbahnen in das Innere der Leiterplatte eingebettet sind. In diesem Fall kann das Leuchtmittel aus der Oberfläche der Leiterplatte hervorragen, sodass die Dekorschicht durch das Leuchtmittel unterbrochen wird oder das Leuchtmittel kann ebenfalls in dem Inneren der Leiterplatte eingebettet sein, wobei die Leiterplatte in diesem Fall eine Strahlungsöffnung hat, durch welche die von dem Leuchtmittel abgegebene Strahlung aus der Leiterplatte und durch die Dekorschicht hindurchstrahlen kann.

Nach einer Ausführungsform der Erfindung wird die Dekorschicht drucktechnisch, insbesondere durch Inkjetdruck oder durch Siebdruck, aufgebracht. Hierdurch lässt sich insbesondere ein Holzdekor, Aluminiumdekor (gebürstet oder glatt) sowie ein Chromdekor aufbringen. Die Aufbringung der Dekorschicht als Holzdekor kann beispielsweise gemäß WO 2008/125261 A1 erfolgen, deren Offenbarungsgehalt hiermit vollumfänglich zum Offenbarungsgehalt und Gegenstand der vorliegenden Patentanmeldung gemacht wird.

Nach einer Ausführungsform der Erfindung beinhaltet die Dekorschicht lichtemittierende elektrochemische Zellen (LECs), insbesondere basierend auf organischen Materialien, insbesondere sog. graphene LECs. Eine solche Dekorschicht aus LECs kann unmittelbar auf die Oberfläche der Leiterplatter aufgedruckt werden oder in Form einer Folie aufgebracht werden. LECs sind an sich aus dem Stand der Technik bekannt vgl. innovations-report 08.02.2010 URL: http://www.innovations-report.de/html/berichte/physik_astronomie/neuartige_lichtemitter_billiger_oleds_14812 3.html
Neuartige Lichtemitter sind billiger als OLEDs Und http://www.elektroniknet.de/opto/news/article/90804/0/Leuchtende_Folien von_der_ Rolle/ 22. August 2012 , *Licht-emittierende elektrochemische Zellen.*

Nach einer Ausführungsform der Erfindung sind die Leuchtmittel als Schicht lichtemittierender elektrochemischer Zellen (LECs) ausgebildet, und die Schicht lichtemittierender elektrochemischer Zellen zwischen der Oberfläche der Leiterplatte und der Dekorschicht angeordnet ist, wobei die Schicht lichtemittierender elektrochemischer Zellen beispielsweise drucktechnisch oder als Folie auf die Oberfläche der Leiterplatte aufgebracht wird, insbesondere unmittelbar auf die Oberfläche der Leiterplatte und die Schicht lichtemittierender elektrochemischer Zellen von der elektronischen Schaltung angesteuert wird.

Die Schicht lichtemittierender elektrochemischer Zellen kann vollflächig auf die Oberfläche der Leiterplatte aufgebracht werden oder in Flächenabschnitten der Oberfläche der Leiterplatte. Im ersteren Fall überdeckt die Dekorschicht die Schicht lichtemittierender elektrochemischer Zellen ebenfalls vollflächig, wohingegen im zweiten Fall die Dekorschicht außerhalb der Flächenabschnitte unmittelbar auf der Oberfläche der Leiterplatte aufgebracht ist und im Bereich der Flächenabschnitte diese überdeckt, wobei es zu einem Niveauausgleich kommen kann, so dass eine eben Außenseite der Dekorschicht resultiert.

Nach einer Ausführungsform der Erfindung hat die elektronische Schaltung der Leiterplatte einen Sensor zur Erzeugung eines Sensorsignals. Aufgrund des Sensorsignals wird das Leuchtmittel von der elektronischen Schaltung ein- oder ausgeschaltet oder es wird die Helligkeit des Leuchtmittels reguliert, um hierdurch einen sogenannten Dimmer zur Verfügung zu stellen.

Bei dem Sensor kann es sich beispielsweise um einen induktiven, kapazitiven oder optischen Näherungssensor handeln, der ebenfalls von der Dekorschicht überdeckt wird. Der Sensor kann in der Leiterplatte eingebettet sein.

Nach einer Ausführungsform der Erfindung ist die elektronische Schaltung zur Ansteuerung einer elektrochromen Schicht ausgebildet, wobei die elektrochrome Schicht das Leuchtmittel überdeckt. Die elektrochrome Schicht hat einen transparenten Zustand und einen transluzenten Zustand, in dem die elektrochrome Schicht opak ist. Wenn das Leuchtmittel ausgeschaltet ist, so befindet sich die elektrochrome Schicht in ihrem opaken Zustand, sodass das Leuchtmittel durch die elektrochrome Schicht, die dann undurchsichtig ist, versteckt wird.

Wenn das Leuchtmittel eingeschaltet wird, beispielsweise aufgrund eines entsprechenden Sensorsignals, so wird auch die elektrochrome Schicht von der elektronischen Schaltung angesteuert, um diese in ihrem transparenten Zustand zu bringen, sodass das Leuchtmittels durch die elektrochrome Schicht hindurch abstrahlen kann. Die Dekorschicht auf der Oberfläche der Leiterplatte kann durch die elektrochrome Schicht unterbrochen werden. Alternativ kann die Dekorschicht die elektrochrome

Schicht überdecken, wobei dann das Leuchtmittel durch die elektrochrome Schicht und die Dekorschicht hindurch abstrahlt.

Nach einer Ausführungsform der Erfindung ist die Strahlungsdurchlässigkeit der Dekorschicht im Bereich des Strahlengangs des Leuchtmittels erhöht, um eine verbesserte Energieeffizienz zu erreichen. Bei drucktechnischer Aufbringung der Dekorschicht kann dies dadurch erreicht werden, dass die Sättigung des Aufdrucks in diesem Bereich reduziert wird.

In einem weiteren Aspekt betrifft die Erfindung ein Möbelstück mit einer Ausführungsform einer erfindungsgemäßen Beleuchtungseinheit. Die Beleuchtungseinheit kann einen integralen Bestandteil des Möbelstücks bilden, wie zum Beispiel eine Sichtblende, Klappe oder ein Wandelement des Möbelstücks.

In einem weiteren Aspekt betrifft die Erfindung ein Kraftfahrzeug-Innenverkleidungsteil, wie zum Beispiel eine Instrumententafel, in die eine Ausführungsform einer erfindungsgemäßen Beleuchtungseinheit integriert ist. Beispielsweise kann die Beleuchtungseinheit auf einem Träger der Instrumententafel angeordnet sein, wobei sich die Dekorschicht über die Leiterplatte hinaus über den Träger der Instrumententafel erstreckt.

In einem weiteren Aspekt betrifft die Erfindung ein Verfahren zur Herstellung einer erfindungsgemäßen Beleuchtungseinheit.

Ausführungsformen der Erfindung sind besonders vorteilhaft, das die Beleuchtungseinheit mit besonders wenigen Schritten und wenigen Komponenten kostengünstig herstellbar ist, besonders robust ist und nahtlos in andere Komponenten, wie z.B. Möbel oder andere Desigobjekte integrierbar ist.

Im Weiteren werden Ausführungsformen der Erfindung mit Bezugnahme auf die Zeichnungen näher erläutert. Es zeigen:
- Figur 1: eine Schnittansicht einer ersten Ausführungsform einer erfindungsgemäßen Beleuchtungseinheit,
- Figur 2: eine Schnittansicht einer zweiten Ausführungsform einer erfindungsgemäßen Beleuchtungseinheit mit einem Sensor,
- Figur 3: eine Schnittansicht einer weiteren Ausführungsform einer erfindungsgemäßen Beleuchtungseinheit, bei der das Leuchtmittel in die Leiterplatte eingebettet ist,
- Figur 4: eine Schnittansicht einer weiteren Ausführungsform einer erfindungsgemäßen Beleuchtungseinheit mit einer elektrochromen Schicht,
- Figur 5: eine perspektivische Ansicht einer erfindungsgemäßen Beleuchtungseinheit im ausgeschalteten Zustand,
- Figur 6: eine perspektivische Ansicht der Beleuchtungseinheit gemäß Figur 5 in eingeschaltetem Zustand.

Nachfolgend werden gleiche oder einander entsprechende Elemente der verschiedenen Ausführungsformen mit identischem Bezugszeichen gekennzeichnet.

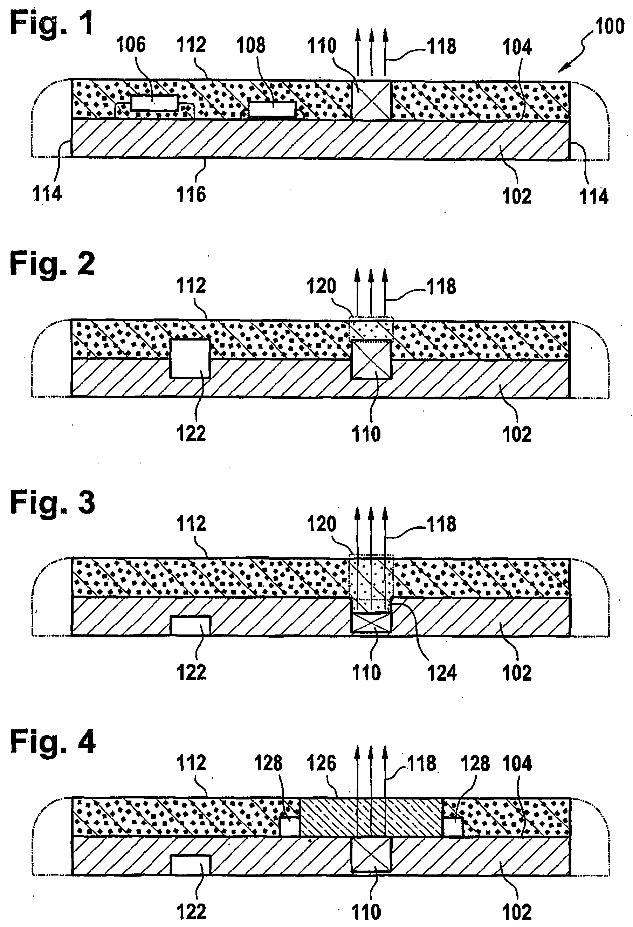

Die Figur 1 zeigt eine Beleuchtungseinheit 100 zur Beleuchtungseinheit eines Raumes. Die Beleuchtungseinheit 100 wird durch eine Leiterplatte 102 gebildet. Die Leiterplatte 102 hat eine Oberfläche 104, bei der es sich um die Bestückungsseite der Leiterplatte 102 handeln kann. In diesem Fall sind auf der Oberfläche 104 verschiedene elektronische Bauelemente und Leiterbahnen angeordnet, von denen exemplarisch ein elektrischer Widerstand 106 und ein Mikroprozessor 108 in der Figur 1 gezeigt sind. Alternativ können die elektronischen Bauelemente ganz oder teilweise in dem Inneren der Leiterplatte 102 eingebettet sein. Ferner kann die Leiterplatte auch beidseitig bestückt sein.

Bei der hier betrachteten Ausführungsform ist die Leiterplatte 102 mit einer LED bestückt. Die LED 110 ist auf der Bestückungsseite der Leiterplatte 102 angeordnet und ragt also über die Oberfläche 104 hervor.

Durch Aufbringung einer Dekorschicht 112 wird die Oberfläche 104 der Leiterplatte 102 sowie eventuell darauf befindliche elektronische Bauelemente, wie zum Beispiel der Widerstand 106 und der Mikroprozessor 108, überdeckt. Bei der hier betrachteten Ausführungsform wird die Dekorschicht 112 durch die LED 110 unterbrochen, so dass die LED 110 unmittelbar in den Raum abstrahl, also nicht durch die Dekorschicht 112. Die Dekorschicht 112 kann sich über die seitlichen Kanten 114 der Leiterplatte 102 erstrecken, wie in der Figur 1 mit gestrichelten Linien dargestellt und/oder über die Rückseite 116 der Leiterplatte.

Bei der Dekorschicht 112 kann es sich zum Beispiel um einen Holzdekor handeln, der durch ein Druckverfahren, zum Beispiel mittels Inkjet oder Siebdruck, aufgebracht wird, oder beispielsweise gemäß dem aus WO 2008/125261 A1 bekannten Verfahren.

Die Beleuchtungseinheit kann in ein Möbelstück integriert werden, wie zum Beispiel in ein Küchenmöbel, um dort Beleuchtungsfunktionen, zum Beispiel einer Arbeitsplatte wahrzunehmen. Ferner kann die Beleuchtungseinheit 100 Teil einer Instrumententafel eines Kraftfahrzeugs sein, wobei sich die Dekorschicht 112 in diesem Fall über einen Träger der Instrumententafel hinweg erstrecken kann.

Gemäß der in Figur 2 gezeigten Ausführungsform ist die LED 110 teilweise in die Leiterplatte 102 versenkt, sodass sie von der Dekorschicht 112 überdeckt wird. In diesem Fall wird das Licht 118 der LED 110 durch die Dekorschicht 112 hindurch abgestrahlt.

Die Dekorschicht 112 kann dabei so ausgebildet sein, dass sie in dem Überbrückuhgsbereich 120, in dem sie die LED 110 überbrückt, wie in der Figur 2 dargestellt, eine erhöhte Strahlungsdurchlässigkeit aufweist. Bei einer drucktechnischen Aufbringung der Dekorschicht 112 kann dies dadurch erreicht werden, dass der Druck in dem Überbrückungsbereich 120 mit einer geringeren Sättigung erfolgt.

Auf diese Art und Weise lässt sich eine durchgehende und glatte Dekorschicht 112 erzeugen, die die LED 110 versteckt und diese erst dann für den Nutzer augenfällig werden lässt, wenn die LED 110 für Beleuchtungszwecke eingeschaltet wird.

Bei der hier betrachteten Ausführungsform beinhaltet die elektronische Schaltung der Leiterplatte 102 einen Sensor 122, der dazu ausgebildet ist, ein Sensorsignal abzugeben, welches von der elektronischen Schaltung ausgewertet wird, um die LED 110 ein- oder auszuschalten,oder um die Helligkeit der LED 110 zu regeln. Beispielsweise kann es sich bei dem Sensor 122 um einen Näherungsschalter handeln. Nähert sich also ein Nutzer der Beleuchtungseinheit 110, so wird dies von dem Sensor 122 sensiert und aufgrund des entsprechenden Sensorsignals wird die LED 110 von der elektronischen Schaltung eingeschaltet. In analoger Art und Weise kann die LED 110 von der elektronischen Schaltung wieder ausgeschaltet werden, wenn sich der Nutzer entfernt.

Bei der hier betrachteten Ausführungsform ist der Sensor 122 teilweise in der Leiterplatte 102 versenkt und wird von der Dekorschicht 112 überdeckt.

Der Sensor 122 und die LED 110 können aber auch in der Leiterplatte 102 eingebettet sein, so wie es in der Figur 3 gezeigt ist. In diesem Fall hat die Leiterplatte 102 eine Öffnung 124, beispielsweise in der Form eines Sacklochs, durch welche hindurch das Licht 118 abgestrahlt werden kann. Auch hier kann wiederum die Strahlungsdurchlässigkeit der Dekorschicht 112 in dem Überbrückungsbereich 120 erhöht sein.

Bei der Ausführungsform gemäß Figur 4 ist eine elektrochrome Schicht 126 auf der Oberfläche 104 der Leiterplatte 102 angeordnet und überdeckt die in der Leiterplatte 102 eingebettete Leuchtdiode 110. Die elektrochrome Schicht 126 wird von Kontaktelementen 128 der elektronischen Schaltung kontaktiert, um eine Spannung über die elektrochrome Schicht 126 anlegen zu können. Die Dekorschicht 112 wird bei der hier betrachteten Ausführungsform durch die elektrochrome Schicht 126 unterbrochen. Alternativ kann aber die Dekorschicht auch die elektrochrome Schicht 126 überdecken, analog zu den Ausführungsformen gemäß Figuren 2 und 3.

Die elektrochrome Schicht 126 hat einen transparenten Zustand und einen opaken Zustand. In dem opaken Zustand kann die elektrochrome Schicht lichtdurchlässig, aber undurchsichtig sein und dabei ein optisches Erscheinungsbild, wie sogenanntes "Milchglas" bieten.

Wenn die Leuchtdiode 110 ausgeschaltet ist, befindet sich die elektrochrome Schicht 126 in ihrem opaken Zustand, sodass die Leuchtdiode 110 von der Frontseite der Beleuchtungseinheit 100 von einem Benutzer nicht wahrgenommen werden kann. Nähert sich nun der Benutzer der Beleuchtungseinheit 100, so wird dies von dem Sensor 122 sensiert und aufgrund des entsprechenden Sensorsignals wird von der elektronischen Schaltung die LED 110 eingeschaltet und eine Spannung zwischen den Kontaktelementen 128 angelegt, sodass die elektrochrome Schicht 126 aus deren opaken Zustand in ihren transparenten Zustand gebracht wird, sodass dann die Leuchtdiode 110 durch die elektrochrome Schicht 126 hindurch abstrahlen kann.

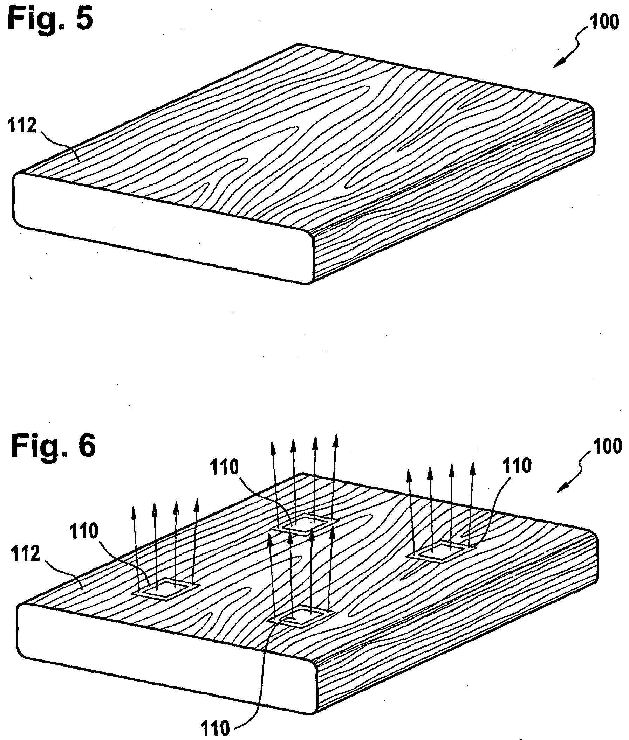

Die Figur 5 zeigt eine Ausführungsform der Beleuchtungseinheit 100, wenn die Leuchtdioden 110 ausgeschaltet sind. In diesem Zustand kann ein Nutzer die Leuchtdioden 110 oder andere elektronische Elemente der Beleuchtungseinheit 100 nicht wahrnehmen. In der hier betrachteten Ausführungsform zeigt die Dekorschicht 112 einen Holzdekor, sodass die Beleuchtungseinheit 100 als Holzelement erscheint.

Nähert sich nun ein Nutzer der Beleuchtungseinheit 100, so werden die LEDs 110 eingeschaltet und strahlen Licht ab, wie in der Figur 6 dargestellt.

### Bezugszeichenliste

- 100: Beleuchtungseinheit
- 102: Leiterplatte
- 104: Oberfläche
- 106: Widerstand
- 108: Prozessor
- 110: Leuchtdiode
- 112: Dekorschicht
- 114: Kante
- 116: Rückseite
- 118: Licht
- 120: Überbrückungsbereich
- 122: Sensor
- 124: Öffnung
- 126: elektrochrome Schicht
- 128: Kontaktelement

## Patentansprüche

1. Beleuchtungseinheit mit einer Leiterplatte (102), die mit einem Leuchtmittels und einer elektronischen Schaltung zur Ansteuerung des Leuchtmittels bestückt ist, wobei das Leuchtmittel eine oder mehrere LEDs, insbesondere OLEDs, und/oder LECs (110) beinhaltet, **gekennzeichnet durch** eine Dekorschicht (112), die unmittelbar auf einer Oberfläche (104) der Leiterplatte (102) aufgebracht ist.

2. Beleuchtungseinheit (100) nach Anspruch 1, wobei die Dekorschicht (112) auf einer durch die Leuchtmittel auf der Oberfläche (104) der Leiterplatte (102) gebildeten Schicht aufgebracht ist.

3. Beleuchtungseinheit (100) nach Anspruch 1, wobei das Leuchtmittel aus der Oberfläche der Leiterplatte (102) hervorragt, sodass die Dekorschicht (112) durch das Leuchtmittel unterbrochen ist.

4. Beleuchtungseinheit (100) nach Anspruch 1 oder 2, wobei das Leuchtmittel aus der Oberfläche der Leiterplatte (102) hervorragt, wobei die Dekorschicht (112) das Leuchtmittel überdeckt und einen Niveauausgleich bewirkt, sodass die Dekorschicht (112) glatt und ohne Unterbrechungen ausgebildet ist.

5. Beleuchtungseinheit (100) nach Anspruch 1 oder 2, wobei das Leuchtmittel in der Leiterplatte (102) versenkt angeordnet ist, die Leiterplatte (102) eine Strahlungsöffnung (124) zum Auslass von Strahlung des Leuchtmittels aufweist, und die Dekorschicht (112) die Strahlungsöffnung (124) überdeckt.

6. Beleuchtungseinheit (100) nach Anspruch 4 oder 5, wobei die Dekorschicht (112) im Bereich (120) der Überdeckung des Leuchtmittels bzw. der Strahlungsöffnung (124) eine erhöhte Strahlungsdurchlässigkeit für von dem Leuchtmittel abgestrahltes Licht (118) aufweist.

7. Beleuchtungseinheit (100) nach einem der vorhergehenden Ansprüche, wobei die Dekorschicht (112) drucktechnisch aufgebracht ist, insbesondere durch Inkjetdruck oder durch Siebdruck.

8. Beleuchtungseinheit (100) nach einem der vorhergehenden Ansprüche, wobei die elektronische Schaltung einen Sensor (122) zur Abgabe eines Sensorsignals aufweist, wobei die elektronische Schaltung zum Ein- oder Ausschalten oder zur Regelung der Leuchtstärke des Leuchtmittels ausgebildet ist.

9. Beleuchtungseinheit (100) nach Anspruch 8, wobei der Sensor (122) in der Leiterplatte (102) eingebettet ist und von der Dekorschicht überdeckt ist.

10. Beleuchtungseinheit (100) nach Anspruch 8 oder 9, wobei es sich bei dem Sensor (122) um einen Näherungssensor, insbesondere einen induktiven, kapazitiven oder optischen Näherungssensor handelt.

11. Beleuchtungseinheit (100) nach einem der vorhergehenden Ansprüche, wobei auf der Oberfläche (104) der Leiterplatte (102) Kontaktelemente (128) der elektronischen Schaltung zur Kontaktierung einer elektrochromen Schicht (126) angeordnet sind, wobei sich die elektrochrome Schicht (126) über das Leuchtmittel erstreckt, wobei die elektrochrome Schicht (126) durch Ansteuerung von der elektronischen Schaltung in einen ersten transparenten Zustand oder einen zweiten transluzenten Zustand bringen lässt.

12. Beleuchtungseinheit (100) nach einem der vorhergehenden Ansprüche 8 bis 11, wobei durch das Sensorsignal beim Einschalten des Leuchtmittels der Zustand der elektrochromen Schicht (126) in den transparenten Zustand gebracht wird.

13. Beleuchtungseinheit (100) nach einem der vorhergehenden Ansprüche, wobei es sich bei der Oberfläche (104) der Leiterpratte (102) um deren Bestückungsseite oder deren Lötseite handelt.

14. Beleuchtungseinheit (100) nach einem der vorhergehenden Ansprüche, wobei ein, mehrere oder alle elektronischen Komponenten der Leiterplatte (102) in der Leiterplatte (102) eingebettet sind.

15. Beleuchtungseinheit (100) nach einem der vorhergehenden Ansprüche, wobei die Dekorschicht lichtemittierende elektrochemische Zellen (LECs), insbesondere graphene LECs, beinhaltet oder aus solchen Zellen besteht, wobei die Dekorschichtounmittelbar auf die Oberfläche (104) der Leiterplatte (102) aufgedruckt oder in Form einer Folie aufgebracht ist.

16. Beleuchtungseinheit (100) nach einem der vorhergehenden Ansprüche, wobei die Leuchtmittel als Schicht lichtemittierender elektrochemischer Zellen (LECs) ausgebildet sind, und die Schicht lichtemittierender elektrochemischer Zellen zwischen der Oberfläche (104) der Leiterplatte (102) und der Dekorschicht (112) angeordnet ist, wobei die Schicht lichtemittierender elektrochemischer Zellen beispielsweise drucktechnisch oder als Folie auf die Oberfläche (104) der Leiterplatte (102) aufgebracht wird, insbesondere unmittelbar auf die Oberfläche (104) der Leiterplatte (102) und die Schicht lichtemittierender elektrochemischer Zellen von der elektronischen Schaltung angesteuert wird.

17. Möbelstück mit einer integrierten Beleuchtungseinheit (100) nach einem der vorhergehenden Ansprüche.

18. Kraftfahrzeug-Innenverkleidungsteil mit einer integrierten Beleuchtungseinheit (100) nach einem der vorhergehenden Ansprüche.

19. Verfahren zur Herstellung einer Beleuchtungseinheit (100) nach einem der vorhergehenden Ansprüche 1 bis 16, wobei die Dekorschicht (112) mittels Inkjet aufgebracht wird.

20. Verfahren nach Anspruch 19, wobei die Sättigung der Bedruckung in dem Überdeckungsbereich des Leuchtmittels bzw. der Strahlungsöffnung (124) reduziert ist.

21. Verfahren nach einem der Ansprüche 19 oder 20, wobei die Dekorschicht (112) lichtemittierende elektrochemische Zellen (LECs), insbesondere graphene LECs, beinhaltet oder aus solchen Zellen besteht, wobei die Dekorschicht (112) unmittelbar auf die Oberfläche (104) der Leiterplatter (102) aufgedruckt oder in Form einer Folie aufgebracht wird.

## Claims

1. A lighting device (100) with a printed circuit board (102) that is populated with a lamp and an electronic circuit to control the lamp, the lamp comprising one or more LEDs, especially OLEDs and/or LECs (110), **characterized by** a decorative layer (112) that is applied directly onto a surface (104) of the printed circuit board (102).

2. The lighting device (100) described in claim 1, wherein the decorative layer (112) is applied onto a layer formed by the lamp on the surface (104) of the printed circuit board (102).

3. The lighting device (100) described in claim 1, wherein the lamp projects off the surface of the printed circuit board (102), so that the decorative layer (112) is interrupted by the lamp.

4. The lighting device (100) described in claim 1 or 2, wherein the lamp projects out of the surface of the printed circuit board (102), the decorative layer (112) covering the lamp and evening out the level of the decorative layer (112), so that it is smooth and uninterrupted.

5. The lighting device (100) described in claim 1 or 2, wherein the lamp is recessed in the printed circuit board (102), the printed circuit board (102) having an emission aperture (124) to let out the emission of the lamp, and the decorative layer (112) covering the emission aperture (124).

6. The lighting device (100) described in claim 4 or 5, wherein the decorative layer (112) has increased transmittance for the light (118) emitted by the lamp in the area (120) of the covering of the lamp or the emission aperture (124).

7. The lighting device (100) described in one of the preceding claims, wherein the decorative layer (112) is applied by a printing technique, in particular by inkjet printing or screen printing.

8. The lighting device (100) described in one of the preceding claims, wherein the electronic circuit has a sensor (122) to give off a sensor signal, the electronic circuit being designed to turn the lamp on or off, or to control its luminosity.

9. The lighting device (100) described in claim 8, wherein the sensor (122) is embedded in the printed circuit board (102) and is covered by the decorative layer.

10. The lighting device (100) described in claim 8 or 9, wherein the sensor (122) is a proximity sensor, in particular an inductive, capacitive, or optical proximity sensor.

11. The lighting device (100) described in one of the preceding claims, wherein the surface (104) of the printed circuit board (102) has contact elements (128) of the electronic circuit arranged on it to contact an electrochromic layer (126) extending over the lamp, the electronic circuit being able to control the electrochromic layer (126) to put it into a first transparent state or a second translucent state.

12. The lighting device (100) described in one of the preceding claims 8 through 11, wherein the sensor signal changes the state of the electrochromic layer (126) to the transparent state when the lamp is turned on.

13. The lighting device (100) described in one of the preceding claims, wherein the surface (104) of the printed circuit board (102) is its component side or its solder side.

14. The lighting device (100) described in one of the preceding claims, wherein one, some, or all electronic components of the printed circuit board (102) are embedded in the printed circuit board (102).

15. The lighting device (100) described in one of the preceding claims, wherein the decorative layer (112) comprises light-emitting electrochemical cells (LECs), especially graphene-based LECs, or consists of such cells, the decorative layer (112) being printed directly onto the surface (104) of the printed circuit board (102), or applied in the form of a film.

16. The lighting device (100) described in one of the preceding claims, wherein the lamp is in the form of a layer of light-emitting electrochemical cells (LECs) that is arranged between the surface (104) of the printed circuit board (102) and the decorative layer (112), the layer of light-emitting electrochemical cells being applied onto the surface (104) of the printed circuit board (102) by a printing technique or in the form of a film, for example, especially directly on the surface (104) of the printed circuit board (102), and the layer of light-emitting electrochemical cells being controlled by the electronic circuit.

17. A piece of furniture with an integrated lighting device (100) described in one of the preceding claims.

18. A motor vehicle interior panel piece with an integrated lighting device (100) described in one of the preceding claims.

19. A process to produce a lighting device (100) described in one of the preceding claims 1 through 16, wherein the decorative layer (112) is applied by means of inkjet printing.

20. The process described in claim 19, wherein the saturation of the printing is reduced in the area covering the lamp or the emission aperture (124).

21. The process described in one of claims 19 or 20, wherein the decorative layer (112) comprises light-emitting electrochemical cells (LECs), especially graphene-based LECs, or consists of such cells, the decorative layer (112) being printed directly onto the surface (104) of the printed circuit board (102) or applied in the form of a film.

## Revendications

1. Unité d'éclairage (100) avec un circuit imprimé (102), qui est équipée d'un moyen d'éclairage et d'un circuit électronique pour la mise en marche du moyen d'éclairage, dans laquelle le moyen d'éclairage est une ou plusieurs diodes électroluminescentes LED, contient notamment des diodes électroluminescentes organiques OLED et/ou des cellules électrochimiques électroluminescentes LEC (110), **caractérisée par** une couche décorative (112) qui est rapportée immédiatement sur une surface (104) du circuit imprimé (102).

2. Unité d'éclairage (100) selon la revendication 1, dans laquelle la couche décorative (112) est rapportée sur une couche formée par les moyens d'éclairage sur la surface (104) du circuit imprimé (102).

3. Unité d'éclairage (100) selon la revendication 1, dans laquelle le moyen d'éclairage dépasse hors de la surface du circuit imprimé (102) de sorte que la couche décorative (112) est interrompue par le moyen d'éclairage.

4. Unité d'éclairage (100) selon les revendications 1 ou 2, dans laquelle le moyen d'éclairage dépasse hors de la surface du circuit imprimé (102), dans laquelle la couche décorative (112) recouvre le moyen d'éclairage et provoque une compensation de niveau de sorte que la couche décorative (112) est faite de manière plane et sans interruptions.

5. Unité d'éclairage (100) selon les revendications 1 ou 2, dans laquelle le moyen d'éclairage est disposé enseveli dans le circuit imprimé (102), le circuit imprimé (102) présente un orifice pour le faisceau (124) destiné à la sortie du faisceau du moyen d'éclairage, et la couche décorative (112) recouvre l'orifice pour le faisceau (124).

6. Unité d'éclairage (100) selon les revendications 4 ou 5, dans laquelle la couche décorative (112) présente une transmission du faisceau plus élevée pour la lumière (118) émise par le moyen d'éclairage dans la zone (120) de recouvrement du moyen d'éclairage, respectivement, de l'orifice pour le faisceau (124).

7. Unité d'éclairage (100) selon l'une des revendications précédentes, dans laquelle la couche décorative (112) est rapportée par impression, notamment par une impression à jet d'encre ou par une impression par sérigraphie.

8. Unité d'éclairage (100) selon l'une des revendications précédentes, dans laquelle le circuit électronique présente un capteur (122) pour la délivrance d'un signal de capteur, dans laquelle le circuit électronique est fait pour la marche, ou l'arrêt, ou la régulation de la luminosité du moyen d'éclairage.

9. Unité d'éclairage (100) selon la revendication 8, dans laquelle le capteur (122) est enseveli dans le circuit imprimé (102) et est recouvert par la couche décorative.

10. Unité d'éclairage (100) selon les revendications 8 ou 9, dans laquelle il s'agit d'un capteur de proximité dans le cas du capteur (122), notamment d'un capteur de proximité inductif, capacitif ou optique.

11. Unité d'éclairage (100) selon l'une des revendications précédentes, dans laquelle des éléments de contact (128) du circuit électronique sont disposés sur la surface (104) du circuit imprimé (102) pour le contact avec une couche électrochrome (126), dans laquelle la couche électrochrome (126) s'étend par-dessus le moyen d'éclairage, dans laquelle la couche électrochrome (126) peut être mise dans un premier état transparent ou dans un deuxième état translucide par la mise en marche par le circuit électronique.

12. Unité d'éclairage (100) selon l'une des revendications précédentes 8 à 11, dans laquelle l'état de la couche électrochrome (126) est placé à l'état transparent par le signal de capteur lors du branchement du moyen d'éclairage.

13. Unité d'éclairage (100) selon l'une des revendications précédentes, dans laquelle il s'agit, dans le cas de la surface (104) du circuit imprimé (102), de sa face équipée ou de sa face soudée.

14. Unité d'éclairage (100) selon l'une des revendications précédentes, dans laquelle un, plusieurs, ou tous les composants électroniques du circuit imprimé (102) sont ensevelis dans le circuit imprimé (102).

15. Unité d'éclairage (100) selon l'une des revendications précédentes, dans laquelle la couche décorative (112) contient des cellules électrochimiques électroluminescentes (LEC), notamment des LEC de graphène, ou est constituée de telles cellules, dans laquelle la couche décorative (112) est imprimée immédiatement sur la surface (104) du circuit imprimé (102) ou est rapportée sous la forme d'un film.

16. Unité d'éclairage (100) selon l'une des revendications précédentes, dans laquelle les moyens d'éclairage sont conçus sous la forme d'une couche de cellules électrochimiques électroluminescentes (LEC), et la couche de cellules électrochimiques électroluminescente est disposée entre la surface (104) du circuit imprimé (102) et la couche décorative (112), dans laquelle la couche de cellules électrochimiques électroluminescentes est rapportée par exemple, par une impression ou en tant que film sur la surface (104) du circuit imprimé (102), notamment immédiatement sur la surface (104) du circuit imprimé (102) et la couche de cellules électrochimiques électroluminescentes est commandée par le circuit électronique.

17. Meuble avec une unité d'éclairage (100) selon l'une des revendications précédentes intégrée.

18. Partie de garniture intérieure d'un véhicule avec une unité d'éclairage (100) selon l'une des revendications précédentes.

19. Procédé de fabrication d'une unité d'éclairage (100) selon l'une des revendications 8 à 16, dans lequel la couche décorative (112) est rapportée au moyen d'un jet d'encre.

20. Procédé selon la revendication 19, dans lequel la saturation de l'impression est réduite dans la zone de recouvrement du moyen d'éclairage, respectivement de l'orifice pour le faisceau (124).

21. Procédé selon l'une des revendications 19 ou 20, dans lequel la couche décorative (112) contient des cellules électrochimiques électroluminescentes (LEC), notamment des LEC de graphène, ou est constituée de telles cellules, dans laquelle la couche décorative (112) est imprimée immédiatement sur la surface (104) du circuit imprimé (102) ou est rapportée sous la forme d'un film.
